# EUROPÄISCHE PATENTANMELDUNG

(11) **EP 3 118 935 A1**
(43) Veröffentlichungstag der Anmeldung: **18.01.2017**
(21) Anmeldenummer: 15176622.7
(22) Anmeldetag: 14.07.2015
(51) Int. Cl.: H01R 12/77, H01R 12/78, H05K 1/14, H01R 31/02

(54) **ELEKTRISCHE KONTAKTIERUNG VON FLEXPLATINEN IN FAHRZEUGLEUCHTEN**

(71) Anmelder: odelo GmbH, 70329 Stuttgart (DE)
(72) Erfinder: Vollmer, Marco, 71332 Waiblingen (DE)
(74) Vertreter: Benninger, Johannes

(57) **Zusammenfassung**

Es wird eine elektrische Kontaktierung (01) von Flexplatinen (02) und eine hiermit ausgestattete Fahrzeugleuchte beschrieben. Die elektrische Kontaktierung (01) umfasst:
- mindestens zwei Flexplatinen (02), und
- einen Randkontaktstecker (03) mit Kontaktmitteln (30),
wobei:
- jede Flexplatine (02) jeweils einen Kontaktierungsabschnitt (21) mit mit ihren Leiterbahnen (20) elektrisch leitend verbundenen, von einem Rand (22) der jeweiligen Flexplatine (02) her zugänglichen Kontaktflächen aufweist,
- die Kontaktierungsabschnitte (21) mindestens zweier Flexplatinen (02) zu einem Stapel (04) angeordnet sind,
- die Ränder (22) der Kontaktierungsabschnitte (21), von denen aus die Kontaktflächen der Flexplatinen (02) zugänglich sind, in dem Stapel (04) übereinanderliegend angeordnet sind, so dass die Ränder (22) der übereinander gestapelten Kontaktierungsabschnitte (21) der mehreren Flexplatinen (02) gemeinsam zumindest einen Teil einer Seite (40) des Stapels (04) ausbilden, von welcher Seite her die Kontaktflächen aller mit ihren Kontaktierungsabschnitten (21) zu dem Stapel (04) angeordneten Flexplatinen (02) zugänglich sind, und
- der Randkontaktstecker (03) mit seinen Kontaktmitteln (30) von der eine Anlegeseite (40) bildenden, durch die in dem Stapel parallel zueinander und übereinander angeordneten Ränder (22), von denen aus die Kontaktflächen der Flexplatinen (02) zugänglich sind, der Kontaktierungsabschnitte (21) gebildeten Seite des Stapels (04) her auf den Stapel (04) aufgesteckt ist, wobei jedes Kontaktmittel (30) des Randkontaktsteckers (03) mindestens mit je einer Kontaktfläche der die Ober- und Unterseite des Stapels (04) bildenden Kontaktierungsabschnitte (21) der Flexplatinen (02) in elektrisch leitender Verbindung steht.

## Beschreibung

Die Erfindung betrifft eine auch als Direktsteckverbindung bezeichenbare elektrische Kontaktierung gemäß dem Oberbegriff des Anspruchs 1 sowie eine solche elektrische Kontaktierung aufweisende Fahrzeugleuchte gemäß dem Oberbegriff des Anspruchs 15.

Ein vorrangiges Entwicklungsziel bei der Herstellung von Fahrzeugen und von Komponenten von Fahrzeugen, wie beispielsweise Fahrzeugleuchten, sind geringe Herstellungskosten.

Im Bereich von elektronischen Schaltungen auf Leiterbahnträgern hat die elektrische Kontaktierung der Leiterbahnträger großen Einfluss auf die Herstellungskosten.

Weit verbreitetste Leiterbahnträger sind kurz als Leiterkarte, Platine oder gedruckte Schaltung (printed circuit board, PCB) bezeichnete Leiterplatten.

Eine Leiterplatte ist ein Träger für elektronische Bauteile. Sie dient der mechanischen Befestigung und elektrischen Verbindung. Nahezu jedes elektronische Gerät enthält eine oder mehrere Leiterplatten.

Eine kostengünstige elektrische Kontaktierung von als Leiterplatten ausgeführten Leiterbahnträgern bedient sich einer Direktsteckverbindung.

Eine Direktsteckverbindung unterscheidet sich dabei von einer indirekten Steckverbindung dadurch, dass nur ein Steckerteil erforderlich ist, das direkt beispielsweise auf einer Leiterplatte vorhandene Leiterbahnen kontaktiert. Bei einer indirekten Steckverbindung ist ein mit den Leiterbahnen beispielsweise einer Leiterplatte verbundenes Gegenstück - beispielsweise ein Buchsenteil - erforderlich, welches das Steckerteil aufnimmt.

Eine Direktsteckverbindung kann beispielsweise mittels auch als Seitenplatinenstecker bezeichneter Randkontaktstecker hergestellt werden.

Ein Randkontaktstecker weist ein Gehäuse auf, welches ein oder mehrere Kontaktmittel teilweise umgibt.

Die einzelnen Kontaktmittel von Randkontaktsteckern sind durch mit Einzelleitungen oder Flachbandleitungen beispielsweise durch Löten oder Crimpen oder Schraubklemmen verbindbare Klammern gebildet, welche eine Leiterplatte umgreifen und dabei auf einer oder auf gegenüberliegenden Seiten der Leiterplatte identisch ausgeführte Leiterbahnen elektrisch kontaktieren.

Ein weit verbreitetes Beispiel von als Seitenplatinenstecker oder Randkontaktstecker für Direktsteckverbindungen einsetzbaren Steckerteilen sind RAST-Steckverbinder (RAST; Raster-Anschluss-Steck-Technik). Hierbei handelt es sich um Steckverbinder der sogenannten Hausgerätenormen RAST 2.5 und RAST 5, wobei die Ziffern den Millimeterabstand zwischen benachbarten Kontaktmitten angeben.

Die Hausgerätespezifikation RAST ist unter dem Dach des Zentralverband Elektrotechnik- und Elektronikindustrie e. V. (ZVEI) durch einen Arbeitskreis der Hersteller von Haushaltsgroßgeräten und von Steckverbindern mit dem Ziel ins Leben gerufen worden, Komponenten zu standardisieren, die Konformität der Steckverbinder verschiedener Hersteller zu gewährleisten und Fehler im Produktionsprozess aufgrund falsch zusammengesteckter Steckverbindungen auszuschließen und damit einhergehend die Montage im Zusammenbau der Endgeräte zu vereinfachen und Fehlverdrahtungen zu minimieren. RAST ermöglicht zudem die Gruppierung von Anschlüssen, wodurch der Einsatz von einzelnen Anschlüssen und individuellen Kabelbäumen vermieden werden kann. In enger Abstimmung zwischen den wichtigsten deutschen Herstellern von Hausgeräten und Steckverbindern entstand ein bis heute gängiger Standard.

Heute sind RAST-Steckverbinder längst Standard für eine Vielzahl von Sensor-, Schalter-, Aktor- und Motorsteuerleitungen, die direkt oder indirekt mit der Leiterplatte und/oder den Komponenten verbunden werden können. Die Vorteile der RAST-Stecker sind auch von anderen Branchen erkannt worden, so dass auch außerhalb der Hausgeräte eine stetig wachsende weltweite Verbreitung zu finden ist, etwa in der Heizungstechnik oder der Automobilindustrie.

Durch DE 10 2010 047 899 A1 ist ein Leuchtmittel mit mindestens einer auf einer Leiterplatte angeordneten Lichtquelle und einem lösbar mit einem Laschenbereich der Leiterplatte verbindbaren, in eine Vormontagestellung und eine Endmontagestellung bringbaren Randkontaktstecker bekannt. Der Randkontaktstecker weist durch Kontaktelemente gebildete Kontaktmittel auf, an denen elektrische Leitungen angeschlossen sind. Die Leiterplatte weist Leiterbahnen auf, die direkt oder indirekt über eine Ansteuereinrichtung mit elektrischen Anschlüssen der Lichtquelle verbunden sind. Die Leiterbahnen haben Kontaktstellen, welche die Kontaktelemente bei in Endmontagestellung befindlichem Randkontaktstecker kontaktieren.

Durch das Umgreifen des Rands eines Leiterbahnträgers können Randkontaktstecker jedoch nicht in Verbindung mit kosten- und anwendungstechnisch sehr vorteilhaften, auch als Leiterbahnflexfolien bezeichneten, so genannten Flexplatinen eingesetzt werden, da deren foliendünne Dickenabmessung es weder zulässt, durch mit Einzelleitungen oder Flachbandleitungen beispielsweise durch Löten oder Crimpen oder Schraubklemmen verbindbare Klammern gebildete Kontaktmittel von Randkontaktsteckern von einem Rand einer Flexplatine her auf eine solche aufzuschieben, ohne Gefahr zu laufen, die Flexplatine dabei zu beschädigen, noch erlaubt, eine Flexplatine zwischen zwei einander gegenüberliegende, einseitig an einer Verbindungsseite beispielsweise mittels eines Stegs vorzugsweise einstückig federelastisch miteinander elektrisch leitfähig verbundene, an der Verbindungsseite um einen vorgegebenen Abstand, der ausreicht, um eine Leiterplatte, bevorzugt eine Standard-Leiterplatte, zwischen die Kontaktschwingen einzuschieben, voneinander beabstandeten Kontaktschwingen eines als Klammer ausgeführten Kontaktmittels eines Randkontaktsteckers zu klemmen und dadurch an ihren Leiterbahnen elektrisch zu kontaktieren.

Für Flexplatinen müssen deshalb bislang teure, indirekte Steckverbindungen mit einem flexplatinenmontierten Buchsen- oder Steckerteil und einem korrespondierenden, leitungsseitig montierten Stecker- oder Buchsenteil verwendet werden. Beispiele für indirekte Steckverbindungen sind in stehender oder liegender Ausführung flexplatinenmontierte Stiftwannen mit und ohne Rastlasche, und leitungsseitig montierte, in die Stiftwannen eingreifende Federleisten mit Crimpanschluss oder mit Schneidklemmenanschluss oder mit Schraubklemmanschluss, an die sowohl Flachbandals auch Einzelleitungen angeschlagen werden können. Die Kontaktmittel des flexplatinenmontierte Stecker- oder Buchsenteils sind mit den Leiterbahnen der Flexplatine beispielsweise durch Löten oder Crimpen elektrisch verbunden.

Im Vergleich zu Randkontaktsteckern sind indirekte Steckverbindungen jedoch etwa um den Faktor Zwölf teurer.

So können im Vergleich zu einer zur elektrischen Kontaktierung von Flexplatinen nach dem Stand der Technik erforderlichen indirekten Steckverbindung als Leiterplatten ausgeführte Leiterbahnträger für etwa ein zwölftel der Kosten mittels einer per Randkontaktstecker ausgeführten Direktsteckverbindung elektrisch kontaktiert werden.

Um dem Kostendruck beispielsweise in der Automobilindustrie gerecht zu werden, wäre es wünschenswert, Flexplatinen mit Randkontaktsteckern zu kombinieren.

Durch Randkontaktstecker hergestellte Direktsteckverbindungen finden jedoch bei Flexplatinen aufgrund der geringen Dicke von Flexplatinen von nur wenigen zehntel Millimetern keine Anwendung.

Eine aus Kostensicht in Verbindung beispielsweise mit in einer Fahrzeugleuchte strakfolgend verbauten, beispielsweise als anorganische Leuchtdioden (Light Emitting Diode; LED) ausgeführten Lichtquellen von Leuchtmitteln oder mit in einer Fahrzeugleuchte verbauten, mittels Flexplatinen elektrisch kontaktierten organischen Leuchtdioden (Organic Light Emitting Diode; OLED) als Lichtquellen anstrebsame Kombination aus Flexplatine und Randkontaktstecker ist demnach nach dem Stand der Technik nicht verwirklichbar.

Zur Kontaktierung von Flexplatinen gibt es bislang folgende Möglichkeiten:
- Lösbare Verbindungen zwischen Displays und Leiterplatten oder zwischen zwei Leiterplatten werden häufig mittels flexiblen Leiterbahnträgern (Flexible Printed Circuits) oder Flachbandkabeln (Flexible Flat Cable) und ZIF-Steckern (ZIF: Zero Insertion Force, Nullkraftstecker) verwirklicht.
- An eine Flexplatine können direkt Kabel angelötet werden, sofern auf der Flexplatine entsprechende Lötaugen aufgebracht sind.
- Eine Flexplatine kann mit Crimpkontakten versehen werden. Auf diese Kontakte kann ein Steckergehäuse aufgeschoben werden. Somit entsteht ein vollwertiger Stecker an der Flexplatine.
- Mehrere Flexplatinen können miteinander verlötet werden.
- Flexplatinen und/oder Kabel auf Flexplatinen können mittels elektrisch leitendem Kleber verbunden werden.
- Flexplatinen und/oder Kabel auf Flexplatinen können mittels Leitkleber verbunden werden.

Alle genannten Möglichkeiten weisen jedoch den Nachteil auf, dass sie teure Stecker und aufwendige Verkabelungen zur Kontaktierung der Flexplatine benötigen. Weiterhin zieht die Verkabelung einen zusätzlichen Aufwand in der Produktion nach sich, was wiederum zusätzliche Kosten verursacht.

Darüber hinaus sind zumindest nicht alle der aufgezeigten Möglichkeiten zum Einsatz in Fahrzeuganwendungen geeignet, da die Stecker beispielsweise keine Verrastung und/oder Verriegelung aufweisen, wodurch sie sich bei Betrieb eines Fahrzeugs auftretenden Schwingungsbelastungen lösen können.

Eine Aufgabe der Erfindung ist es, eine kostengünstige elektrische Kontaktierung von Flexplatinen in Fahrzeugleuchten sowie eine mit einer entsprechenden elektrischen Kontaktierung ausgestattete Fahrzeugleuchte zu schaffen.

Die Aufgabe wird jeweils durch die Merkmale eines der unabhängigen Ansprüche gelöst. Weitere vorteilhafte Ausgestaltungen werden durch die abhängigen Ansprüche beschrieben.

Ein erster Gegenstand der Erfindung betrifft demnach eine elektrische Kontaktierung von jeweils mit Leiterbahnen versehenen Flexplatinen.

Die elektrische Kontaktierung umfasst mindestens zwei Flexplatinen und einen Randkontaktstecker mit Kontaktmitteln.

Jede Flexplatine weist jeweils einen Kontaktierungsabschnitt mit ihren Leiterbahnen elektrisch leitend verbundenen, von einem Rand der jeweiligen Flexplatine her zugänglichen Kontaktflächen auf. Jede Flexplatine weist darüber hinaus mindestens einen sich an ihren Kontaktierungsabschnitt anschließenden, weiterführenden Teil auf, entlang dem sich die mittels der Kontaktflächen im Kontaktierungsabschnitt elektrisch kontaktierten Leiterbahnen erstrecken. Die Kontaktflächen bilden hierbei jeweils die elektrischen Anschlüsse einer jeden Flexplatine.

Die Kontaktierungsabschnitte mindestens zweier Flexplatinen sind zu einem Stapel angeordnet. Mit anderen Worten sind mehrere, mindestens jedoch zwei Flexplatinen mit ihren Kontaktierungsabschnitten zu einem Stapel angeordnet.

Als gleichartige elektrische Anschlüsse vorgesehene Kontaktflächen der mit ihren Kontaktierungsabschnitten zu einem Stapel angeordneten Flexplatinen sind in dem Stapel bevorzugt einander zumindest überlappend, vorzugsweise einander überdeckend, und besonders bevorzugt deckungsgleich angeordnet.

Die Ränder der Kontaktierungsabschnitte, von denen aus die Kontaktflächen der Flexplatinen zugänglich sind, sind in dem Stapel übereinanderliegend angeordnet, so dass die Ränder der übereinander gestapelten Kontaktierungsabschnitte der mehreren Flexplatinen gemeinsam zumindest einen Teil einer Seite des Stapels ausbilden, von welcher Seite her die Kontaktflächen aller mit ihren Kontaktierungsabschnitten zu dem Stapel angeordneten Flexplatinen zugänglich sind.

Die elektrische Kontaktierung umfasst zusätzlich zu dem Stapel von Kontaktierungsabschnitten mit von einer als Seite her zugänglichen Kontaktflächen aller mit ihren Kontaktierungsabschnitten zu dem Stapel angeordneten Flexplatinen einen Randkontaktstecker mit Kontaktmitteln, beispielsweise mit einer zumindest der maximalen Anzahl von Kontaktflächen einer mit ihrem Kontaktierungsabschnitt zu dem Stapel gestapelten Flexplatine entsprechenden Zahl von Kontaktmitteln.

Der Randkontaktstecker ist mit seinen beispielsweise mit einem weiterführenden elektrischen Anschluss dienenden elektrischen Leitungen verbundenen Kontaktmitteln von der eine Anlegeseite bildenden, durch die in dem Stapel parallel zueinander und übereinander angeordneten Rändern, von denen aus die Kontaktflächen der Flexplatinen zugänglich sind, der Kontaktierungsabschnitte gebildeten Seite des Stapels her auf den Stapel aufgesteckt, wobei jedes Kontaktmittel des Randkontaktsteckers mindestens mit je einer Kontaktfläche der Kontaktierungsabschnitte der die Ober- und Unterseite des Stapels bildenden Flexplatinen in elektrisch leitender Verbindung steht.

Dabei kann ein Kontaktmittel grundsätzlich sowohl mit einer Kontaktfläche der Kontaktierungsabschnitte der die Ober- und Unterseite des Stapels bildenden Flexplatinen in elektrisch leitender Verbindung stehen, wobei beide Kontaktflächen gleichermaßen gemeinsam elektrisch kontaktiert werden, oder es kann ein Kontaktmittel nur mit einer Kontaktfläche eines Kontaktierungsabschnitts einer der die Ober- und Unterseite des Stapels bildenden Flexplatinen in elektrisch leitender Verbindung stehen, wobei jede Kontaktfläche individuell elektrisch kontaktiert ist.

Vorteile gegenüber dem Stand der Technik ergeben sich dadurch, dass mehrere Flexplatinen mit einem Randkontaktstecker gemeinsam sicher mechanisch und elektrisch kontaktiert werden können. Hierdurch können beispielsweise bei der Herstellung elektrischer Verbindungen zu OLEDs insbesondere in Fahrzeugheckleuchten Kosten und Ressourcen gespart werden. Die sonst nötigen Verkabelungskonzepte werden massiv vereinfacht, wodurch auch in der Produktion und Montage Ressourcen wie Zeit und Kosten eingespart werden können. Es werden insgesamt weniger Einkaufteile - wie etwa Stecker - benötigt.

Zusätzliche Vorteile ergeben sich durch eine Einsparung der herzustellenden elektrischen Verbindungen bei zwei oder mehreren elektrisch zu kontaktierenden Flexplatinen. Bei der Verwendung mehrerer Flexplatinen oder generell mehrerer Leiterbahnträger in Fahrzeugleuchten muss bislang jeder Leiterbahnträger separat angeschlossen werden.

Die besonderen Vorzüge der elektrischen Kontaktierung in Verbindung mit der Herstellung elektrischer Verbindungen zu OLEDs sind durch den bei deren Verwendung in Fahrzeugleuchten erforderlichen Aufbau bedingt.

Eine OLED ist ein leuchtendes Dünnschichtbauelement aus organischen halbleitenden Materialien mit mindestens einer Emitterschicht, das sich von den anorganischen Leuchtdioden (LED) dadurch unterscheidet, dass keine einkristallinen Materialien erforderlich sind. Im Vergleich zu anorganischen LEDs lassen sich OLEDs daher in kostengünstiger Dünnschichttechnik herstellen. OLEDs ermöglichen dadurch die Herstellung flächiger Lichtquellen, die einerseits sehr dünn und andererseits, als durch die Lichtscheibe einer Kraftfahrzeugleuchte hindurch sichtbare leuchtende Fläche eingesetzt einen besonders homogenes Erscheinungsbild aufweisen.

OLEDs weisen eine Schichtstapelhöhe in der Größenordnung von etwa 100 nm auf. Die Stapel sind eingeschlossen zwischen metallischen Schichten für Anode und Kathode. Zum Schutz gegen Wasser, Sauerstoff sowie zum Schutz gegen andere Umwelteinflüsse, wie etwa Kratzbeschädigung und/oder Druckbelastung sind OLEDs typischerweise mit einem anorganischen Material insbesondere mit Glas verkapselt. Zwar gibt es Anstrengungen, das Glas durch Kunststoff zu ersetzen, die jedoch nicht vom gewünschten Erfolg gekrönt sind, weil die Dichtigkeit der alternativen Materialien für die Verkapselung nicht ausreichend gut genug ist. Um OLEDs als Lichtquellen von für den Einsatz in Kraftfahrzeugleuchten vorgesehenen Leuchtmitteln verwenden zu können, müssen daher Maßnahmen getroffen werden, um die Deckschichten aus Glas bei der Montage und im Betrieb einer Fahrzeugleuchte vor Beschädigung zu schützen. Diesem Schutz kann beispielsweise eine elektrische Verbindung zu einer OLED via einer Flexplatine beitragen. Die Flexplatine verhindert hierbei die Übertragung von den Deckschichten aus Glas gefährlich werdenden Biegemomenten auf die OLED, da sie aufgrund ihrer dünnen Ausführung bereits bei weit geringeren Biegemomenten nachgibt und sich deformiert, als die Deckschichten.

Die Leiterbahnen der Flexplatine können beispielsweise durch ACF-Bonding (ACF; Anisotropic conductive film) vermittels Leitkleber mit den elektrischen Anschlüssen der OLED elektrisch verbunden werden.

Bei einem Leitkleber handelt es sich um einen elektrisch leitfähigen Klebstoff.

Leitkleber bestehen aus den Klebmittel und anorganischen, elektrisch leitfähigen Füllstoffen. Deren Anteil liegt bei etwa 30 %. Wegen der verwendeten metallischen Füllstoffe sind die Verbindungsstellen auch thermisch gut leitfähig. Zu den gut geeigneten Füllstoffen zählen Silber, Gold, Palladium, Nickel und Platin.

Eine eigene Klasse unter den Leitklebern bilden so genannte anisotrope Leitkleber. Als Füllmaterial werden kugelförmige leitende Teilchen eingesetzt. Das Gesamtvolumen wird nur zu 5 % durch das leitfähige Material gebildet. Dadurch wird eine lokal begrenzte elektrische Verbindung erreicht. Bei einem Auftrag als dünner Film wird die elektrische Verbindung nur vertikal zwischen den miteinander verklebten Oberflächen, aber nicht horizontal aufgebaut, da sich die Kugeln nicht berühren. Das gestattet den großflächigen Auftrag des Klebers ohne Justage. Nachteilig ist die Begrenzung der Betriebstemperatur auf etwa 80° Celsius und eine prinzipbedingt implizierte Kurzschlusswahrscheinlichkeit.

Eine Verbindung mit einem Leitkleber ist zwar weniger leitfähig als eine Lötverbindung, ist aber elastisch und dadurch mechanisch belastbarer. Eine hohe Elastizität erreichen beispielsweise Silikonkleber.

Die Anzahl der Kontaktflächen der Kontaktierungsabschnitte der Flexplatinen entspricht beispielsweise zumindest einer Zahl von beispielsweise zum Betrieb wenigstens einer durch ein oder mehrere via auf den Flexplatinen ausgebildeten Leiterbahnen elektrisch kontaktierte, beispielsweise untereinander elektrisch verbundene Elektronikbauteile gebildeten Einrichtung erforderlichen elektrischen Anschlüssen.

Bei der Einrichtung kann es sich beispielsweise um eine Elektronikschaltung, die einen Teil, etwa eine Ansteuereinrichtung, eines eine oder mehrere Lichtquellen umfassenden Leuchtmittels einer Fahrzeugleuchte handeln. Alternativ oder zusätzlich kann die Einrichtung eine oder mehrere Lichtquellen eines Leuchtmittels einer Fahrzeugleuchte umfassen, beispielsweise eine oder mehrere LEDs und/oder OLEDs je Flexplatine.

In dem Stapel kann zusätzlich zu den Kontaktierungsabschnitten wenigstens zweier Flexplatinen mindestens ein Verstärkungselement angeordnet sein. Das Verstärkungselement versteift den Stapel, wodurch der Randkontaktstecker leichter aufgeschoben werden kann. Darüber hinaus erhöht das Verstärkungselement die Dicke oder Höhe des Stapels, wodurch es möglich ist, Standard-Randkontaktstecker, etwa dergestalt, wie sie zur Herstellung von Direktsteckverbindungen für Leiterplatten eingesetzt werden, zu verwenden.

Das Verstärkungselement hat bevorzugt plattenförmige Gestalt mit planparallelen Ober- und Unterseiten sowie umlaufenden, die Ober- und Unterseite miteinander verbindenden Schmalseiten. Zumindest eine Schmalseite verläuft hierbei parallel zu den in dem Stapel parallel zueinander und übereinander angeordneten Rändern der Kontaktierungsabschnitte, von denen aus die Kontaktflächen der Flexplatinen zugänglich sind.

Die mit den als elektrische Anschlüsse dienenden Kontaktflächen versehenen Oberflächen der Kontaktierungsabschnitte der Flexplatinen sind in dem Stapel vorzugsweise dem Verstärkungselement abgewandt. Die elektrisch zu kontaktierenden Leiterbahnen der Flexplatinen liegen damit bevorzugt dem Verstärkungselement abgewandt. Ferner sind hierbei die Kontaktflächen der Kontaktierungsabschnitte der Flexplatinen zumindest von wenigstens einer dem Verstärkungselement abgewandten Seite her zugänglich in einer parallel zu den planparallel gegenüberliegenden, beispielsweise durch dessen Ober- und Unterseite gebildeten Oberflächen des Verstärkungselements verlaufenden Ebene gelegen.

Dadurch wird sowohl eine zuverlässige elektrische Kontaktierung gewährleistet, als auch die Möglichkeit geschaffen, bei entsprechender Ausgestaltung der Kontaktflächen der Kontaktierungsabschnitte der Flexplatinen mittels eines Randkontaktsteckers eine beidseitige elektrische Kontaktierung einhergehend mit einer besonders hohen Kontaktsicherheit zu erhalten.

Das Verstärkungselement kann beidseitig mit Leiterbahnen versehen sein, von denen auf unterschiedlichen Oberflächen einander gegenüberliegende Leiterbahnen beispielsweise mittels Durchkontaktierungen elektrisch miteinander verbunden sein können.

Verfügen die Flexplatinen ebenfalls je auf ihren beiden Oberflächen über miteinander verbundene Leiterbahnen, ergibt sich hierdurch eine besonders zuverlässige Kontaktierung sowohl im mit einem Verstärkungselement mit durchkontaktierten Leiterbahnen versehenen Stapel, als auch via des beidseitig den Stapel kontaktierenden Randkontaktsteckers. Darüber hinaus können so mehr als zwei Flexplatinen übereinander im Stapel angeordnet werden, mit oder ohne Verstärkungselement.

Der Randkontaktstecker kann ein Gehäuse aufweisen, welches das eine oder die mehreren Kontaktmittel teilweise umgibt.

Jedes der Kontaktmittel des Randkontaktsteckers kann eine Klammer umfassen mit zwei einander gegenüberliegenden, einseitig an einer Verbindungsseite beispielsweise mittels eines Stegs vorzugsweise einstückig in dem Sinne federelastisch miteinander elektrisch leitfähig verbundenen Kontaktschwingen, dass die freien Enden der Kontaktschwingen einer Klammer in einem Ausgangszustand aneinander anliegen oder um einen geringen Abstand von beispielsweise nur wenigen zehntel Millimetern einander gegenüberliegend voneinander beabstandet sind, und unter Überwindung der Federbelastung voneinander weg ausgelenkt werden können. Die Kontaktschwingen sind an der Verbindungsseite um einen vorgegebenen Abstand voneinander beabstandet, der vorzugsweise ausreicht, um den Stapel aus den Kontaktierungsabschnitten wenigstens zweier Flexplatinen sowie gegebenenfalls eines oder mehrerer Verstärkungselemente, zwischen die Kontaktschwingen einzuschieben.

Zumindest in einem Bereich an den von der Verbindungsseite beabstandeten freien Enden der Kontaktschwingen herrscht wie zuvor beschrieben ein geringerer Abstand, so dass ein zwischen die Kontaktschwingen der einen oder mehreren als Kontaktmittel des Randkontaktsteckers dienenden Klammern eingeschobener Stapel zumindest im Bereich deren freier Enden federelastisch eingeklemmt wird. Dabei ist von den freien Enden her kommend vorzugsweise eine Aufweitung vorgesehen, um das Einschieben eines Stapels zwischen die Kontaktschwingen zu erleichtern.

Ist der Randkontaktstecker von der die Anlegeseite bildenden Seite des Stapels her auf den Stapel aufgesteckt, klemmt das freie Ende zumindest je einer Kontaktschwinge jeder der als Klammern ausgeführten Kontaktmittel des Randkontaktsteckers die Kontaktierungsabschnitte der die Ober- und Unterseite des Stapels bildenden Flexplatinen an je einer ihrer Kontaktflächen.

An den Kontaktmitteln sind beispielsweise zu einem Kabelbaum zusammengefasste elektrische Leitungen angeschlossen oder anschließbar.

Die Kontaktflächen der Flexplatinen werden bevorzugt durch zumindest von einer Oberfläche der Flexplatinen her zugängliche Leiterbahnen gebildet. Das oder die Kontaktmittel des Randkontaktsteckers kontaktieren in einer Endmontagestellung des Randkontaktsteckers die eine oder mehrere Kontaktflächen der Flexplatinen. In der Endmontagestellung greift der Randkontaktstecker von einer die Anlegeseite bildenden Seite des übereinander angeordnet mindestens zwei Kontaktierungsabschnitte sowie gegebenenfalls ein oder mehrere Verstärkungselemente umfassenden Stapels her kommend beispielsweise mit je einer Kontaktschwinge seiner als Klammern ausgeführten Kontaktmittel den Stapel von einer durch einen Kontaktierungsabschnitt einer ersten Flexplatine gebildeten, ersten Oberfläche her, und mit je einer Kontaktschwinge seiner als Klammern ausgeführten Kontaktmittel den Stapel von einer durch einen Kontaktierungsabschnitt einer zweiten Flexplatine gebildeten, der ersten Oberfläche gegenüberliegenden zweiten Oberfläche her, so dass der Stapel von beiden Seiten von der die Anlegeseite bildenden Seite her kommend an seinen beiden einander gegenüberliegenden, durch die Anlegeseite miteinander verbundenen Oberflächen von den beiden Kontaktschwingen des mindestens einen als Klammer ausgeführten Kontaktmittels umgriffen, und jede Kontaktfläche unter Herstellung eines elektrischen Kontakts zwischen ihr und einem Kontaktmittel zwischen den Kontaktschwingen der als Klammern ausgeführten Kontaktmittel des Randkontaktsteckers geklemmt wird.

Dabei können beide Kontaktschwingen einer Klammern gleichzeitig auf beiden Oberflächen des Stapels elektrische Kontakte zu dann zugleich miteinander kontaktierten Kontaktflächen der die Ober- und Unterseite des Stapels bildenden Kontaktierungsabschnitte der Flexplatinen herstellen, oder es kann eine Klammer jeweils nur mit einer ihrer Kontaktschwingen nur mit einer Kontaktfläche eines der die Ober- und Unterseite des Stapels bildenden Kontaktierungsabschnitts einen elektrischen Kontakt herstellen. Die letztgenannte Ausgestaltungsmöglichkeit erlaubt zumindest die Flexplatinen, deren Kontaktierungsabschnitte die Ober- und Unterseite des Stapels bilden, individuell und unabhängig voneinander zu kontaktieren. Hierdurch können mit nur einem Randkontaktstecker beispielsweise unterschiedliche, vermittels je einer Flexplatine elektrisch angeschlossene Lichtquellen individuell betrieben werden.

Die Dicke beziehungsweise Höhe des Stapels korrespondiert vorzugsweise mit dem vorgegebenen Abstand zwischen den Kontaktschwingen derart, dass der Stapel zwischen die Kontaktschwingen der als Klammern ausgebildeten Kontaktmittel des Randkontaktsteckers unter Herstellung eines elektrischen Kontakts zwischen den Kontaktmitteln des Randkontaktsteckers und den Kontaktflächen der Kontaktierungsabschnitte der Flexplatinen eingeschoben werden kann.

Beispielsweise entspricht die Dicke beziehungsweise Höhe des Stapels bevorzugt der Dicke einer zwischen die als Kontaktmittel des Randkontaktsteckers dienenden Klammern einschiebbaren Leiterplatte.

Als Verstärkungselement eignet sich beispielsweise eine FR-4 Platine.

FR-4 oder auch FR4 bezeichnet eine Klasse von schwer entflammbaren und flammenhemmenden Verbundwerkstoffen bestehend aus Epoxidharz und Glasfasergewebe. Die Abkürzung FR steht für flame retardant (flammenhemmend) und entspricht der Anforderung von UL94V-0. FR-4 und ist in verschiedenen Varianten verfügbar. Zur Verbesserung der Flammhemmung wird der Verbundwerkstoff mit chemischen Stoffen wie polybromierte Diphenylether basierend auf Brom versetzt, in der halogenfreien Variante entfällt dieser Zusatz. Der Verbundwerkstoff FR-4 wurde 1968, neben anderen Verbundwerkstoffen, von der National Electrical Manufacturers Association (NEMA) in den Eigenschaften in der Spezifikation NEMA Ll1 festgelegt.

FR-4 weist im Gegensatz zu ähnlichen Verbundwerkstoffen wie FR-2, sogenanntes Hartpapier, eine bessere Kriechstromfestigkeit und eine geringere Wasseraufnahme auf. Weiterer Vorteil von FR-4 ist die gute Haftbarkeit, welche das dauerhafte Anbringen von Leiterbahnstrukturen aus Kupfer auf dem Trägermaterial gewährleistet.

Leiterplatten mit FR-4 als elektrisch isolierendem Material werden gängig und daher im hiesigen Kontext als FR-4 Platinen bezeichnet.

Die Flexplatinen und das Verstärkungselement können miteinander korrespondierende Haltemittel aufweisen, wie beispielsweise einen oder mehrere auf einer oder mehreren, beispielsweise planparallel gegenüberliegenden Seiten des Verstärkungselements aufstehende Vorsprünge und/oder Stifte und/oder Haken, um nur einige denkbare Ausgestaltungen zu nennen, und in den Flexplatinen vorgesehene Ausnehmungen, beispielsweise Löcher, mittels denen die Flexplatinen beispielsweise an ihren Kontaktierungsabschnitten am Verstärkungselement eingehängt werden können. Beispielsweise eignen sich als korrespondierende Haltemittel am Verstärkungselement angeordnete Pins und Löcher in der Flexplatine. Die Abmessungen des Verstärkungselements können hierbei größer sein, als die der Kontaktierungsabschnitte. Das Verstärkungselement steht hierbei jedoch nicht an derjenigen, die Anlegeseite bildenden Seite des Stapels über die Kontaktierungsabschnitte über, von welcher Seite her die Kontaktflächen aller mit ihren Kontaktierungsabschnitten zu dem Stapel angeordneten Flexplatinen zugänglich sind.

Mindestens eine der Flexplatinen kann alternativ oder zusätzlich auf ihrer den Leiterbahnen abgewandten, rückwärtigen Seite flächig mit dem Verstärkungselement verbunden sein, beispielsweise durch Kleben.

Das Verstärkungselement kann ein zur Halterung einer Flexplatine oder einer eine Flexplatine umfassenden Einrichtung, beispielsweise eines Leuchtmittels mit einer oder mehreren Lichtquellen, in einer Fahrzeugleuchte vorgesehenes Trägerelement, welches beispielsweise einen Verlauf oder eine Geometrie vorgibt, ganz oder teilweise umfassen und/oder von einem solchen Trägerelement ganz oder teilweise umfasst sein und/oder ein solches Trägerelement bilden und/oder von einem solchen Trägerelement gebildet sein.

Es ist ersichtlich, dass die Erfindung durch eine Direktsteckverbindung verwirklicht sein kann, die sich durch einen Randkontaktstecker auszeichnet, der von einer als Anlegeseite dienenden Seite her auf einen Stapel aufgeschoben ist, der an seiner Ober- und Unterseite durch je einen Kontaktierungsabschnitt einer Flexplatine mit von dem der Anlegeseite zugewandten Rand her für die Kontaktmittel des Randkontaktsteckers zugänglichen Kontaktflächen gebildet ist, wobei zwischen den die Ober- und Unterseite des Stapels bildenden Kontaktierungsabschnitten der zumindest zwei Flexplatinen mindestens ein Verstärkungselement und/oder gegebenenfalls ein oder mehrere Kontaktierungsabschnitte einer oder mehrerer weiterer Leiterbahnträger, beispielsweise weiterer Flexplatinen vorgesehen sein können.

Grundsätzlich kann der Leiterbahnträger, dessen Kontaktierungsabschnitt die Ober- oder Unterseite des Stapels bildet, anderer Art sein, als der Leiterbahnträger, dessen Kontaktierungsabschnitt die gegenüberliegende Unter- oder Oberseite des Stapels bildet. So kann beispielsweise die Ober- oder Unterseite des Stapels durch einen Kontaktierungsabschnitt einer Flexplatine gebildet sein, wohingegen die gegenüberliegende Unter- oder Oberseite des Stapels durch einen Kontaktierungsabschnitt einer Leiterplatte oder eines in MID-Technik hergestellten Leiterbahnträgers gebildet sein kann.

Mittels einer zuvor beschriebenen, auch als Direktsteckverbindung bezeichenbaren elektrischen Kontaktierung elektrisch kontaktierte Flexplatinen können beispielsweise zur OLED-Kontaktierung eingesetzt werden, an die sie beispielsweise mittels ACF-Bonding mechanisch und elektrisch angeschlossen sein können.

Die als Direktsteckverbindung ausgeführte elektrische Kontaktierung kann alternativ oder zusätzlich einzelne oder eine Kombination mehrerer einleitend in Verbindung mit dem Stand der Technik und/oder in einem oder mehreren der zum Stand der Technik erwähnten Dokumente und/oder in der nachfolgenden Beschreibung zu den in den Zeichnungen dargestellten Ausführungsbeispielen beschriebene Merkmale aufweisen.

Anwendungsbeispiele der Erfindung finden sich beispielsweise bei der elektrischen Kontaktierung von OLEDs von einem Kabelsatz für interne Leuchtenkontaktierung, beim Kontaktieren von auf Flexfolien angeordneten LEDs, beim Kontaktieren von auf Flexfolien angeordneten Steuerschaltungen und dergleichen.

Zusätzliche, über die Lösung der gestellten Aufgabe und/oder über die voran zu den einzelnen Merkmalen genannten Vorteile hinausgehende Vorteile gegenüber dem Stand der Technik sind nachfolgend aufgeführt.

Vorteile gegenüber dem Stand der Technik sind die Schaffung einer Möglichkeit, gleichzeitig mehrere Felxplatinen und/oder Flexplatinen und andere Leiterbahnträger zugleich kostengünstig mittels Randkontaktsteckern elektrisch zu kontaktieren.

Weitere Vorteile ergeben sich durch eine Ressourceneinsparung. Die sonst nötigen Verkabelungskonzepte werden massiv vereinfacht, wodurch auch in der Produktion und Montage Ressourcen wie Zeit und Kosten eingespart werden können.

Vorteile gegenüber dem Stand der Technik sind außerdem eine kompakte Bauform der Direktsteckverbindung und dass eine Anpassung der Dicke des Stapels an die Weite der Kontaktmittel des Randkontaktsteckers möglich ist. Dies ist vorteilhaft, da die Flexplatinen nicht eine Standarddicke aufweisen, sondern abhängig vom Stromfluss, etc. in Ihren Einzelschichtdicken ausgelegt werden. Das Verstärkungselement kann dies mit seiner Dicke, die individuell ausgelegt werden kann -in Grenzen- ausgleichen.

Randkontaktstecker für Standard-Leiterplatten sind wesentlich kostengünstiger als die beispielsweise zur elektrischen Kontaktierung von Flexplatinen bislang erforderlichen indirekten Steckverbindungen aus einem leitungsseitig montierten Buchsen- oder Steckerteil und einem beispielsweise in SMD-Technik leiterbahnträgerseitig montiertes, das leitungsseitig montierte Buchsen- oder Steckerteil aufnehmendes leiterplattenmontiertes Stecker- oder Buchsenteil. Darüber hinaus stellt die sichere Verriegelung einer indirekten Steckverbindung in der Montage eine häufige Fehlerquelle dar. Die in Fahrzeugleuchten zum Einsatz kommenden Direktsteckverbindungen mittels Randkontaktsteckern können hingegen konstruktiv leicht gegen unvollständiges Stecken gesichert werden.

Hierdurch entfällt das Problem der Herstellung und Kontrolle einer sicheren Verrastung bzw. Verriegelung indirekter Steckverbindungen in der Montage.

Ein zweiter Gegenstand der Erfindung betrifft eine Fahrzeugleuchte mit mindestens einer mit einer zuvor beschriebenen elektrischen Kontaktierung hergestellten elektrischen Verbindung beispielsweise zu einer oder mehrerer Lichtquellen wenigstens eines Leuchtmittels der Fahrzeugleuchte. Die Fahrzeugleuchte kann beispielsweise als eine Heckleuchte oder als ein Tagfahrlicht oder als ein Fahrzeugscheinwerfer ausgeführt sein. Die Fahrzeugleuchte erlaubt, alle zuvor zur elektrischen Kontaktierung genannten Vorteile zu nutzen.

Die Erfindung wird nachfolgend anhand von in der Zeichnung dargestellter Ausführungsbeispiele näher erläutert. Die Größenverhältnisse der einzelnen Elemente zueinander in den Figuren entsprechen nicht immer den realen Größenverhältnissen, da einige Formen vereinfacht und andere Formen zur besseren Veranschaulichung vergrößert im Verhältnis zu anderen Elementen dargestellt sind. Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figur erforderlich sind. Die dargestellten Ausführungsformen stellen lediglich Beispiele dar, wie die erfindungsgemäße elektrische Kontaktierung und/oder Fahrzeugleuchte ausgestaltet sein kann und stellen keine abschließende Begrenzung dar. Es zeigen in schematischer Darstellung:
- Fig. 1: ein erstes Ausführungsbeispiel einer als Direktsteckverbindung bezeichenbaren elektrischen Kontaktierung zweier zur elektrischen Verbindung und/oder zum elektrischen Anschluss von Lichtquellen und/oder Elektronikbauteilen verwendeten Flexplatinen in einer Draufsicht.
- Fig. 2: ein zweites Ausführungsbeispiel einer als Direktsteckverbindung bezeichenbaren elektrischen Kontaktierung zweier zur elektrischen Verbindung und/oder zum elektrischen Anschluss von Lichtquellen und/oder Elektronikbauteilen verwendeten Flexplatinen in einer Seitenansicht.
- Fig. 3: ein drittes Ausführungsbeispiel einer als Direktsteckverbindung bezeichenbaren elektrischen Kontaktierung zweier zur elektrischen Verbindung und/oder zum elektrischen Anschluss von Lichtquellen und/oder Elektronikbauteilen verwendeten Flexplatinen in einer Draufsichtt.

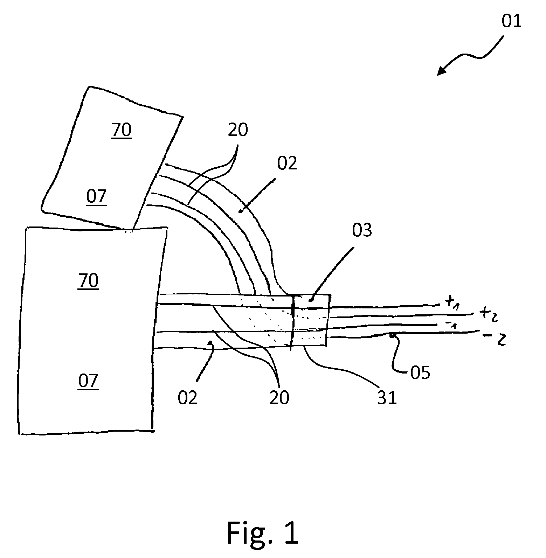

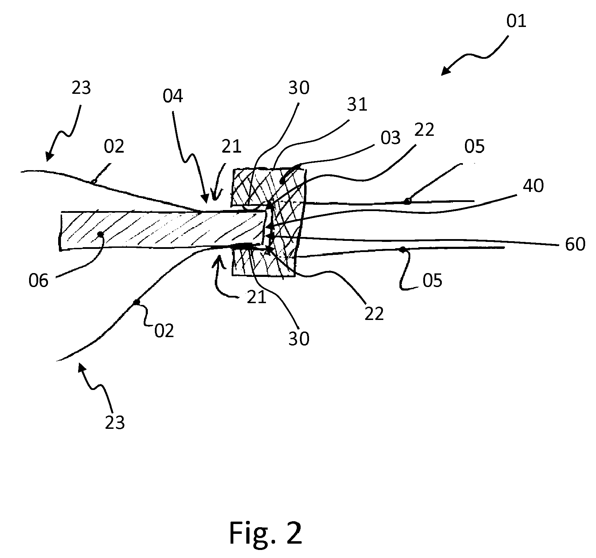

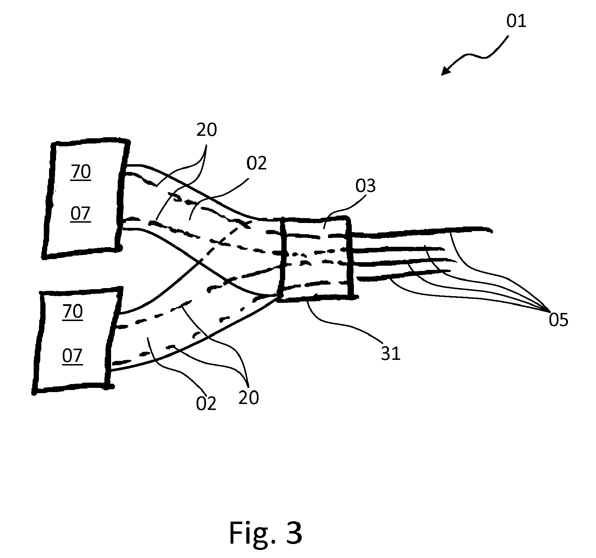

Eine in Fig. 1, Fig. 2, Fig. 3 ganz oder in Teilen dargestellte elektrische Kontaktierung 01 von jeweils mit Leiterbahnen 20 versehenen Flexplatinen 02 insbesondere in Fahrzeugleuchten umfasst:
- mindestens zwei Flexplatinen 02, und
- einen Randkontaktstecker 03 mit Kontaktmitteln 30,
   wobei:
- jede Flexplatine 02 jeweils einen Kontaktierungsabschnitt 21 mit mit ihren Leiterbahnen 20 elektrisch leitend verbundenen, von einem Rand 22 der jeweiligen Flexplatine 02 her zugänglichen Kontaktflächen aufweist, und
- die Kontaktierungsabschnitte 21 mindestens zweier Flexplatinen 02 zu einem Stapel 04 angeordnet sind.

Dabei sind die Kontaktierungsabschnitte 21 mehrerer, mindestens jedoch zweier Flexplatinen 02 zu einem Stapel 04 angeordnet.

Die Ränder 22 der Kontaktierungsabschnitte 21, von denen aus die Kontaktflächen der Flexplatinen 02 zugänglich sind, sind in dem Stapel 04 übereinanderliegend angeordnet, so dass die Ränder 22 der übereinander gestapelten Kontaktierungsabschnitte 21 der mehreren Flexplatinen 02 gemeinsam zumindest einen Teil einer als Anlegeseite 40 dienenden Seite des Stapels 04 ausbilden, von welcher Anlegeseite 40 her die Kontaktflächen aller mit ihren Kontaktierungsabschnitten 21 zu dem Stapel 04 angeordneten Flexplatinen 02 zugänglich sind.

Die Kontaktflächen zumindestens der obersten und der untersten Flexplatine 02 in dem Stapel 04 befinden sich hierbei auf die Ober- und Unterseite des Stapels 04 bildenden Oberflächen der Kontaktierungsabschnitte 21 der Flexplatinen 02.

Die elektrische Kontaktierung 01 umfasst zusätzlich zu dem zumindest aus Kontaktierungsabschnitten 21 mit von einer als Seite her zugänglichen Kontaktflächen aller mit ihren Kontaktierungsabschnitten 21 zu dem Stapel 04 angeordneten Flexplatinen 02 bestehenden Stapel 04 einen Randkontaktstecker 03 mit Kontaktmitteln 30.

Der Randkontaktstecker 03 mit seinen beispielsweise mit einem weiterführenden elektrischen Anschluss dienenden elektrischen Leitungen 05 verbundenen Kontaktmitteln 30 ist von der eine Anlegeseite 40 bildenden, durch die in dem Stapel 04 parallel zueinander und übereinander angeordneten Rändern 22, von denen aus die Kontaktflächen der Flexplatinen 02 zugänglich sind, der Kontaktierungsabschnitte gebildeten Seite des Stapels 04 her auf den Stapel 04 aufgesteckt.

Jedes Kontaktmittel 30 des Randkontaktsteckers 03 steht mindestens mit je einer Kontaktfläche wenigstens der die Ober- und Unterseite des Stapels 04 bildenden Kontaktierungsabschnitte 21 der Flexplatinen 02 in elektrisch leitender Verbindung.

Die Kontaktflächen bilden jeweils die elektrischen Anschlüsse einer jeden Flexplatine 02.

Die Anzahl der Kontaktflächen der Kontaktierungsabschnitte 21 einer Flexplatine 02 entspricht beispielsweise zumindest einer Zahl von beispielsweise zum Betrieb wenigstens einer durch ein oder mehrere via auf der Flexplatine 02 ausgebildeten Leiterbahnen 20 elektrisch kontaktierte, beispielsweise untereinander elektrisch verbundene Elektronikbauteile gebildeten Einrichtung 07 erforderlichen elektrischen Anschlüssen.

Bei der Einrichtung 07 kann es sich beispielsweise um eine Elektronikschaltung, die einen Teil, etwa eine Ansteuereinrichtung, eines eine oder mehrere Lichtquellen umfassenden Leuchtmittels einer Fahrzeugleuchte handeln. Alternativ oder zusätzlich kann die Einrichtung 07 eine oder mehrere Lichtquellen eines Leuchtmittels einer Fahrzeugleuchte umfassen, beispielsweise eine oder mehrere LEDs und/oder OLEDs 70 je Flexplatine 02.

Vorzugsweise weist jede Flexplatine 02 mindestens einen sich an ihren Kontaktierungsabschnitt 21 anschließenden, weiterführenden Teil 23 auf, entlang dem sich die mittels der Kontaktflächen im Kontaktierungsabschnitt 21 elektrisch kontaktierten Leiterbahnen 20 erstrecken.

Als gleichartige elektrische Anschlüsse vorgesehene Kontaktflächen der mit ihren Kontaktierungsabschnitten 21 zu einem Stapel 04 angeordneten Flexplatinen 02 können in dem Stapel 04 einander zumindest überlappend und/oder einander überdeckend, und/oder deckungsgleich angeordnet sein.

Der Randkontaktstecker ist vorzugsweise mit einer zumindest der maximalen Anzahl von Kontaktflächen einer der mit ihren Kontaktierungsabschnitten 21 zu dem Stapel 21 gestapelten Flexplatinen 02 entsprechenden Zahl von Kontaktmitteln 30 ausgestattet.

So kann beispielsweise eine der Summe der Kontaktflächen der mit ihren Kontaktierungsabschnitten 21 zu dem Stapel 21 angeordneten Flexplatinen 02 entsprechende Zahl von Kontaktmitteln 30 vorgesehen sein, wobei die mit ihren Kontaktierungsabschnitten 21 eine Ober- oder Unterseite des Stapels 04 bildenden Flexplatinen 02 unabhängig voneinander elektrisch kontaktiert sind.

Ein Kontaktmittel 30 kann demnach sowohl mit einer Kontaktfläche der Kontaktierungsabschnitte 21 der die Ober- und Unterseite des Stapels 04 bildenden Flexplatinen 02 in elektrisch leitender Verbindung stehen, wobei beide Kontaktflächen gleichermaßen gemeinsam elektrisch kontaktiert werden, oder ein Kontaktmittel 30 kann nur mit einer Kontaktfläche eines Kontaktierungsabschnitts 21 einer der die Ober- oder Unterseite des Stapels 04 bildenden Flexplatine 02 in elektrisch leitender Verbindung stehen, wobei die jeweilige Kontaktfläche individuell elektrisch kontaktiert ist.

In dem Stapel 04 ist vorzugsweise zusätzlich zu den Kontaktierungsabschnitten 21 wenigstens zweier Flexplatinen 21 mindestens ein Verstärkungselement 06 angeordnet.

Das Verstärkungselement 06 versteift den Stapel 04, wodurch der Randkontaktstecker 03 leichter aufgeschoben werden kann. Darüber hinaus erhöht das Verstärkungselement 06 die Dicke oder Höhe des Stapels 04, wodurch es möglich ist, Standard-Randkontaktstecker, etwa dergestalt, wie sie zur Herstellung von Direktsteckverbindungen für Leiterplatten eingesetzt werden, zu verwenden.

Als Verstärkungselement 06 eignet sich beispielsweise eine FR-4 Platine.

Besonders bevorzugt ist das Verstärkungselement 06 zwischen zwei Kontaktierungsabschnitten 21 zweier Flexplatinen 02 in dem Stapel 04 angeordnet.

Das Verstärkungselement 06 weist bevorzugt plattenförmige Gestalt mit planparallelen Ober- und Unterseiten sowie umlaufenden, die Ober- und Unterseite miteinander verbindenden Schmalseiten auf. Zumindest eine Schmalseite 60 verläuft parallel zu den in dem Stapel 04 parallel zueinander und übereinander angeordneten Rändern 22 der Kontaktierungsabschnitte 21, von denen aus die Kontaktflächen der Flexplatinen 02 aus zugänglich sind.

Die mit den als elektrische Anschlüsse dienenden Kontaktflächen versehenen Oberflächen der Kontaktierungsabschnitte 21 der Flexplatinen 02 sind in dem Stapel 04 dem Verstärkungselement 06 abgewandt angeordnet.

Die elektrisch zu kontaktierenden Leiterbahnen 20 der Flexplatinen 02 liegen ebenfalls bevorzugt dem Verstärkungselement 04 abgewandt. Ferner sind hierbei die Kontaktflächen der Kontaktierungsabschnitte 21 der Flexplatinen 02 zumindest von wenigstens einer dem Verstärkungselement 06 abgewandten Seite her zugänglich in einer parallel zu den planparallel gegenüberliegenden, beispielsweise durch dessen Ober- und Unterseite gebildeten Oberflächen des Verstärkungselements 06 verlaufenden Ebene gelegen.

Dadurch wird sowohl eine zuverlässige elektrische Kontaktierung gewährleistet, als auch die Möglichkeit geschaffen, bei entsprechender Ausgestaltung der Kontaktflächen der Kontaktierungsabschnitte 21 der Flexplatinen 02 mittels eines Randkontaktsteckers 03 eine beidseitige elektrische Kontaktierung einhergehend mit einer besonders hohen Kontaktsicherheit zu erhalten.

Das Verstärkungselement 06 kann beidseitig mit Leiterbahnen versehen sein, von denen auf unterschiedlichen Oberflächen einander gegenüberliegende Leiterbahnen beispielsweise mittels Durchkontaktierungen elektrisch miteinander verbunden sein können.

Verfügen die Flexplatinen 02 ebenfalls je auf ihren beiden Oberflächen über miteinander verbundene Leiterbahnen 20, ergibt sich hierdurch eine besonders zuverlässige Kontaktierung sowohl im mit einem Verstärkungselement 06 mit durchkontaktierten Leiterbahnen versehenen Stapel 04, als auch via eines beidseitig den Stapel 04 kontaktierenden Randkontaktsteckers 03. Darüber hinaus können so mehr als zwei Flexplatinen 02 übereinander in dem Stapel 04 angeordnet werden, mit oder ohne Verstärkungselement 06.

Das Verstärkungselement 06 kann ein zur Halterung einer Flexplatine 02 oder einer eine Flexplatine 02 umfassenden Einrichtung 07, beispielsweise eines Leuchtmittels mit einer oder mehreren Lichtquellen, in einer Fahrzeugleuchte vorgesehenes Trägerelement, welches beispielsweise einen Verlauf oder eine Geometrie vorgibt, ganz oder teilweise umfassen und/oder von einem solchen Trägerelement ganz oder teilweise umfasst sein und/oder ein solches Trägerelement bilden und/oder von einem solchen Trägerelement gebildet sein.

Die Flexplatinen 02 und das Verstärkungselement 06 können miteinander korrespondierende Haltemittel aufweisen, wie beispielsweise einen oder mehrere auf einer oder mehreren, beispielsweise planparallel gegenüberliegenden Seiten des Verstärkungselements 06 aufstehende Vorsprünge und/oder Stifte und/oder Haken, um nur einige denkbare Ausgestaltungen zu nennen, und in den Flexplatinen 02 vorgesehene Ausnehmungen, beispielsweise Löcher, mittels denen die Flexplatinen 02 beispielsweise an ihren Kontaktierungsabschnitten 21 am Verstärkungselement 06 eingehängt werden können. Beispielsweise eignen sich als korrespondierende Haltemittel am Verstärkungselement 06 angeordnete Pins und Löcher in den Flexplatinen 02. Die Abmessungen des Verstärkungselements 06 können hierbei größer sein, als die der Kontaktierungsabschnitte 21. Das Verstärkungselement 06 steht hierbei jedoch nicht an derjenigen, die Anlegeseite 40 bildenden Seite des Stapels 04 über die Kontaktierungsabschnitte 21 über, von welcher Seite her die Kontaktflächen aller mit ihren Kontaktierungsabschnitten 21 zu dem Stapel 04 angeordneten Flexplatinen 02 aus zugänglich sind.

Mindestens eine der Flexplatinen 21 kann auf ihrer den Leiterbahnen 20 abgewandten, rückwärtigen Seite flächig mit dem Verstärkungselement 06 verbunden sein, beispielsweise durch Kleben.

Der Randkontaktstecker 03 weist vorzugsweise ein Gehäuse 31 auf, welches das eine oder die mehreren Kontaktmittel 30 teilweise umgibt.

Jedes der Kontaktmittel 30 des Randkontaktsteckers 03 kann beispielsweise eine Klammer umfassen mit zwei einander gegenüberliegenden, einseitig an einer Verbindungsseite beispielsweise mittels eines Stegs vorzugsweise einstückig in dem Sinne federelastisch miteinander elektrisch leitfähig verbundenen Kontaktschwingen, dass die freien Enden der Kontaktschwingen einer Klammer in einem Ausgangszustand aneinander anliegen oder um einen geringen Abstand von beispielsweise nur wenigen zehntel Millimetern einander gegenüberliegend voneinander beabstandet sind, und unter Überwindung der Federbelastung voneinander weg ausgelenkt werden können. Die Kontaktschwingen sind an der Verbindungsseite um einen vorgegebenen Abstand voneinander beabstandet, der vorzugsweise ausreicht, um den Stapel 04 aus den Kontaktierungsabschnitten 21 wenigstens zweier Flexplatinen 02 sowie gegebenenfalls eines oder mehrerer Verstärkungselemente 06, zwischen die Kontaktschwingen einzuschieben.

Zumindest in einem Bereich an den von der Verbindungsseite beabstandeten freien Enden der Kontaktschwingen herrscht wie zuvor beschrieben ein geringerer Abstand, so dass ein zwischen die Kontaktschwingen der einen oder mehreren als Kontaktmittel 30 des Randkontaktsteckers 03 dienenden Klammern eingeschobener Stapel 04 mit den an seiner Ober- und Unterseite befindlichen Kontaktflächen zumindest im Bereich deren freier Enden federelastisch eingeklemmt wird. Dabei ist von den freien Enden her kommend vorzugsweise eine Aufweitung vorgesehen, um das Einschieben eines Stapels 04 zwischen die Kontaktschwingen zu erleichtern.

Ist der Randkontaktstecker 03 von der die Anlegeseite 40 bildenden Seite des Stapels 04 her auf den Stapel 04 aufgeschoben, beispielsweise aufgesteckt, klemmt das freie Ende zumindest je einer Kontaktschwinge jeder der als Klammern ausgeführten Kontaktmittel 30 des Randkontaktsteckers 03 die Kontaktierungsabschnitte 21 der die Ober- und Unterseite des Stapels 04 bildenden Flexplatinen 02 an je einer ihrer Kontaktflächen.

Die Kontaktflächen der Flexplatinen 02 werden bevorzugt durch zumindest von einer Oberfläche der einzelnen Flexplatinen 02 her zugängliche Leiterbahnen 20 gebildet. Das oder die Kontaktmittel 30 des Randkontaktsteckers 03 kontaktieren in einer Endmontagestellung des Randkontaktsteckers 03 die eine oder mehrere Kontaktflächen der Flexplatinen 02. In der Endmontagestellung greift der Randkontaktstecker 03 von einer die Anlegeseite 40 bildenden Seite des übereinander angeordnet mindestens zwei Kontaktierungsabschnitte 21 sowie gegebenenfalls ein oder mehrere Verstärkungselemente 06 umfassenden Stapels 04 her kommend beispielsweise mit je einer Kontaktschwinge seiner als Klammern ausgeführten Kontaktmittel 30 den Stapel 04 von einer durch einen Kontaktierungsabschnitt 21 einer ersten Flexplatine 02 gebildeten, ersten Oberfläche her, und mit je einer Kontaktschwinge seiner als Klammern ausgeführten Kontaktmittel 30 den Stapel 04 von einer durch einen Kontaktierungsabschnitt 21 einer zweiten Flexplatine 02 gebildeten, der ersten Oberfläche gegenüberliegenden zweiten Oberfläche her, so dass der Stapel 04 von beiden einander abgewandten Ober- und Unterseiten von der die Anlegeseite 40 bildenden Seite her kommend an seinen beiden einander gegenüberliegenden, durch die Anlegeseite 40 miteinander verbundenen Oberflächen von den beiden Kontaktschwingen des mindestens einen als Klammer ausgeführten Kontaktmittels 30 umgriffen, und jede Kontaktfläche unter Herstellung eines elektrischen Kontakts zwischen ihr und einem Kontaktmittel 30 zwischen den Kontaktschwingen der als Klammern ausgeführten Kontaktmittel 30 des Randkontaktsteckers 03 geklemmt wird.

Dabei können beide Kontaktschwingen einer Klammern gleichzeitig auf beiden Oberflächen des Stapels 04 elektrische Kontakte zu dann zugleich miteinander kontaktierten Kontaktflächen der die Ober- und Unterseite des Stapels 04 bildenden Kontaktierungsabschnitte 21 der Flexplatinen 02 herstellen, oder es kann eine Klammer jeweils nur mit einer ihrer Kontaktschwingen nur mit einer Kontaktfläche eines der die Ober- und Unterseite des Stapels 04 bildenden Kontaktierungsabschnitts 21 einer Flexplatine 02 einen elektrischen Kontakt herstellen. Die letztgenannte Ausgestaltungsmöglichkeit erlaubt zumindest die Flexplatinen 02, deren Kontaktierungsabschnitte 21 die Ober- und Unterseite des Stapels 04 bilden, individuell und unabhängig voneinander zu kontaktieren. Hierdurch können mit nur einem Randkontaktstecker 03 beispielsweise unterschiedliche, vermittels je einer Flexplatine 02 elektrisch angeschlossene Einrichtungen 07 individuell betrieben werden.

Die Dicke beziehungsweise Höhe des Stapels 04 korrespondiert vorzugsweise mit dem vorgegebenen Abstand zwischen den Kontaktschwingen derart, dass der Stapel 04 zwischen die Kontaktschwingen der als Klammern ausgebildeten Kontaktmittel 30 des Randkontaktsteckers 03 unter Herstellung eines elektrischen Kontakts zwischen den Kontaktmitteln 30 des Randkontaktsteckers 03 und den Kontaktflächen der Kontaktierungsabschnitte 21 der Flexplatinen 02 eingeschoben werden kann.

Beispielsweise entspricht die Dicke beziehungsweise Höhe des Stapels 04 bevorzugt der Dicke einer zwischen die als Kontaktmittel 30 des Randkontaktsteckers 03 dienenden Klammern einschiebbaren Leiterplatte.

Um einem fehlerhaften Aufschieben des Randkontaktsteckers 03 auf den Stapel 04 vorzubeugen, kann der Randkontaktstecker 03 mit einer asymmetrisch angeordneten Rippe versehen sein, die zwischen seinen Kontaktmitteln 30 hervorsteht. Am Stapel 04 ist hierbei ein mit der Rippe korrespondierender Einschnitt vorgesehen, in welchen die Rippe des Randkontaktsteckers beim Aufschieben auf den Stapel eindringen muss, damit der Randkontaktstecker 03 auf den Stapel 04 aufgeschoben werden kann. Rippe und Einschnitt können darüber hinaus mit korrespondierenden Rastmitteln versehen sein, um ein unbeabsichtigtes Lösen der elektrischen Kontaktierung 01 zu verhindern.

Die elektrische Kontaktierung 01 kann vorteilhaft in einer Fahrzeugleuchte eingesetzt werden. Dabei dient die elektrische Kontaktierung bevorzugt der Herstellung einer elektrischen Verbindung innerhalb der Fahrzeugleuchte, beispielsweise zwischen OLEDs 70, wobei jede OLED 70 mit ihren elektrischen Anschlüssen mit den Leiterbahnen 20 einer Flexplatine verbunden ist, von denen wiederum mehrere Flexplatinen 02 mittels der beschriebenen elektrischen Kontaktierung 01 elektrisch weiterkontaktiert sind.

Wichtig ist hervorzuheben, dass die Erfindung durch eine als Direktsteckverbindung verwirklichte elektrische Kontaktierung 01 ausgeführt sein kann, die sich durch einen Randkontaktstecker 03 auszeichnet, der von einer als Anlegeseite 40 dienenden Seite her auf einen Stapel 04 aufgeschoben ist, der an seiner Ober- und Unterseite durch je einen Kontaktierungsabschnitt 21 einer Flexplatine 02 mit von dem der Anlegeseite 40 zugewandten Rand 22 her für die Kontaktmittel 30 des Randkontaktsteckers 03 zugänglichen Kontaktflächen gebildet ist, wobei zwischen den die Ober- und Unterseite des Stapels 04 bildenden Kontaktierungsabschnitten 21 der zumindest zwei Flexplatinen 02 mindestens ein Verstärkungselement 06 und/oder gegebenenfalls ein oder mehrere Kontaktierungsabschnitte 21 einer oder mehrerer weiterer Leiterbahnträger, beispielsweise weiterer Flexplatinen 02 vorgesehen sein können.

In diesem Zusammenhang ebenfalls wichtig ist hervorzuheben, dass ein Leiterbahnträger, dessen Kontaktierungsabschnitt die Ober- oder Unterseite des Stapels 04 bildet, anderer Art sein kann, als der Leiterbahnträger, dessen Kontaktierungsabschnitt die gegenüberliegende Unter- oder Oberseite des Stapels 04 bildet. So kann beispielsweise die Ober- oder Unterseite des Stapels 04 durch einen Kontaktierungsabschnitt 21 einer Flexplatine 02 gebildet sein, wohingegen die gegenüberliegende Unter- oder Oberseite des Stapels 04 durch einen Kontaktierungsabschnitt beispielsweise einer Leiterplatte oder eines in MID-Technik hergestellten Leiterbahnträgers gebildet sein kann.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Ansprüchen beinhaltet, auch wenn dieses Merkmal oder diese Kombination selbst nicht explizit in den Ansprüchen oder Ausführungsbeispielen angegeben ist.

Die Erfindung ist insbesondere im Bereich der Herstellung von Fahrzeugleuchten, insbesondere Kraftfahrzeugleuchten, sowie Komponenten von Fahrzeugleuchten, wie etwa ein oder mehrere Elektronikbauteile und/oder Lichtquellen umfassenden Leuchtmitteln gewerblich anwendbar.

### Bezugszeichenliste

- 01: elektrische Kontaktierung
- 02: Flexplatine
- 03: Randkontaktstecker
- 04: Stapel
- 05: Leitung
- 06: Verstärkungselement
- 07: Einrichtung
- 20: Leiterbahn
- 21: Kontaktierungsabschnitt
- 22: Rand
- 23: weiterführender Teil
- 30: Kontaktmittel
- 31: Gehäuse
- 40: Anlegeseite
- 60: Schmalseite
- 70: OLED

## Patentansprüche

1. Elektrische Kontaktierung (01) von Flexplatinen (02) umfassend:
- mindestens zwei Flexplatinen (02), und
- einen Randkontaktstecker (03) mit Kontaktmitteln (30),
wobei:
- jede Flexplatine (02) jeweils einen Kontaktierungsabschnitt (21) mit mit ihren Leiterbahnen (20) elektrisch leitend verbundenen, von einem Rand (22) der jeweiligen Flexplatine (02) her zugänglichen Kontaktflächen aufweist,
- die Kontaktierungsabschnitte (21) mindestens zweier Flexplatinen (02) zu einem Stapel (04) angeordnet sind,
- die Ränder (22) der Kontaktierungsabschnitte (21), von denen aus die Kontaktflächen der Flexplatinen (02) zugänglich sind, in dem Stapel (04) übereinanderliegend angeordnet sind, so dass die Ränder (22) der übereinander gestapelten Kontaktierungsabschnitte (21) der mehreren Flexplatinen (02) gemeinsam zumindest einen Teil einer Seite (40) des Stapels (04) ausbilden, von welcher Seite her die Kontaktflächen aller mit ihren Kontaktierungsabschnitten (21) zu dem Stapel (04) angeordneten Flexplatinen (02) zugänglich sind, und
- der Randkontaktstecker (03) mit seinen Kontaktmitteln (30) von der eine Anlegeseite (40) bildenden, durch die in dem Stapel parallel zueinander und übereinander angeordneten Ränder (22), von denen aus die Kontaktflächen der Flexplatinen (02) zugänglich sind, der Kontaktierungsabschnitte (21) gebildeten Seite des Stapels (04) her auf den Stapel (04) aufgesteckt ist, wobei jedes Kontaktmittel (30) des Randkontaktsteckers (03) mindestens mit je einer Kontaktfläche der die Ober- und Unterseite des Stapels (04) bildenden Kontaktierungsabschnitte (21) der Flexplatinen (02) in elektrisch leitender Verbindung steht.

2. Elektrische Kontaktierung nach Anspruch 1, wobei als gleichartige elektrische Anschlüsse vorgesehene Kontaktflächen der mit ihren Kontaktierungsabschnitten (21) zu einem Stapel (04) angeordneten Flexplatinen (02) in dem Stapel (04) einander zumindest überlappend und/oder einander überdeckend, und/oder deckungsgleich angeordnet sind.

3. Elektrische Kontaktierung nach Anspruch 1 oder 2, wobei der Randkontaktstecker (03) mit einer zumindest der maximalen Anzahl von Kontaktflächen einer der mit ihren Kontaktierungsabschnitten (21) zu dem Stapel (04) angeordneten Flexplatinen (02) entsprechenden Zahl von Kontaktmitteln (30) ausgestattet ist.

4. Elektrische Kontaktierung nach Anspruch 1, 2 oder 3, wobei ein Kontaktmittel (30) sowohl mit einer Kontaktfläche der Kontaktierungsabschnitte (21) der die Ober- und Unterseite des Stapels (04) bildenden Flexplatinen (02) in elektrisch leitender Verbindung steht, wobei beide Kontaktflächen gleichermaßen gemeinsam elektrisch kontaktiert werden, oder ein Kontaktmittel (30) nur mit einer Kontaktfläche eines Kontaktierungsabschnitts (21) einer der die Ober- oder Unterseite des Stapels (04) bildenden Flexplatine (02) in elektrisch leitender Verbindung steht, wobei die jeweilige Kontaktfläche individuell elektrisch kontaktiert ist.

5. Elektrische Kontaktierung nach einem der Ansprüche 1 bis 4, wobei in dem Stapel (04) mindestens ein Verstärkungselement (06) angeordnet ist.

6. Elektrische Kontaktierung nach Anspruch 5, wobei das Verstärkungselement (06) zwischen zwei Kontaktierungsabschnitten (21) zweier Flexplatinen (02) in dem Stapel (04) angeordnet ist.

7. Elektrische Kontaktierung nach Anspruch 5 oder 6, wobei das Verstärkungselement (06) plattenförmige Gestalt mit planparallelen Ober- und Unterseiten sowie umlaufenden, die Ober- und Unterseite miteinander verbindenden Schmalseiten (60) aufweist, wobei zumindest eine Schmalseite (60) parallel zu den in dem Stapel (04) parallel zueinander und übereinander angeordneten Rändern (22) der Kontaktierungsabschnitte (21), von denen aus die Kontaktflächen der Flexplatinen (02) zugänglich sind, verläuft.

8. Elektrische Kontaktierung nach einem der Ansprüche 5, 6 oder 7, wobei die mit den Kontaktflächen versehenen Oberflächen der Kontaktierungsabschnitte (21) der Flexplatinen (02) in dem Stapel (04) dem Verstärkungselement (06) abgewandt sind.

9. Elektrische Kontaktierung nach einem der Ansprüche 5 bis 8, wobei die Flexplatinen (02) und das Verstärkungselement (06) miteinander korrespondierende Haltemittel aufweisen.

10. Elektrische Kontaktierung nach einem der Ansprüche 5 bis 9, wobei mindestens eine der Flexplatinen (02) auf ihrer den Leiterbahnen (20) abgewandten, rückwärtigen Seite flächig mit dem Verstärkungselement (06) verbunden ist.

11. Elektrische Kontaktierung nach einem der voranstehenden Ansprüche, wobei der Randkontaktstecker (03) ein Gehäuse (31) aufweist, welches die Kontaktmittel (30) teilweise umgibt.

12. Elektrische Kontaktierung nach einem der voranstehenden Ansprüche, wobei jedes der Kontaktmittel (30) des Randkontaktsteckers (03) eine Klammer umfasst mit zwei einander gegenüberliegenden, einseitig an einer Verbindungsseite federelastisch miteinander elektrisch leitfähig verbundenen Kontaktschwingen, wobei die Kontaktschwingen an der Verbindungsseite um einen vorgegebenen Abstand voneinander beabstandet sind, der ausreicht, um den Stapel (04) zwischen die Kontaktschwingen einzuschieben.

13. Elektrische Kontaktierung nach einem der voranstehenden Ansprüche, wobei an den Kontaktmitteln (30) elektrische Leitungen (05) angeschlossen oder anschließbar sind.

14. Elektrische Kontaktierung nach einem der voranstehenden Ansprüche, wobei der Randkontaktstecker (03) mit einer asymmetrisch angeordneten Rippe versehen ist, die zwischen seinen Kontaktmitteln (30) hervorsteht, und am Stapel (04) ein mit der Rippe korrespondierender Einschnitt vorgesehen ist, durch welchen hindurch die Rippe des Randkontaktsteckers in den Einschnitt am Stapel (04) hineinfährt.

15. Fahrzeugleuchte mit einer elektrischen Kontaktierung (01) nach einem der voranstehenden Ansprüche.
